(19) Europäisches Patentamt / European Patent Office / Office européen des brevets

(11) **EP 3 048 566 B1**

(12) **EUROPEAN PATENT SPECIFICATION**

(45) Date of publication and mention of the grant of the patent:
**19.06.2019 Bulletin 2019/25**

(51) Int Cl.:
*G06Q 10/00* (2012.01)  *G01R 21/00* (2006.01)
*H02J 13/00* (2006.01)  *H04Q 9/00* (2006.01)
*G01R 21/133* (2006.01)  *G06Q 50/06* (2012.01)

(21) Application number: **14845911.8**

(22) Date of filing: **08.09.2014**

(86) International application number:
**PCT/JP2014/073680**

(87) International publication number:
**WO 2015/041090 (26.03.2015 Gazette 2015/12)**

(54) **INFORMATION PROCESSING DEVICE AND INFORMATION PROCESSING METHOD**

INFORMATIONSVERARBEITUNGSVORRICHTUNG UND INFORMATIONSVERARBEITUNGSVERFAHREN

DISPOSITIF ET PROCÉDÉ DE TRAITEMENT D'INFORMATIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.09.2013 JP 2013194575**

(43) Date of publication of application:
**27.07.2016 Bulletin 2016/30**

(73) Proprietor: **Kabushiki Kaisha Toshiba**
**Minato-ku**
**Tokyo 105-8001 (JP)**

(72) Inventors:
• **YANO Toru**
  **Tokyo 105-8001 (JP)**
• **IMAHARA Shuichiro**
  **Tokyo 105-8001 (JP)**
• **TAKEUCHI Ryosuke**
  **Tokyo 105-8001 (JP)**

(74) Representative: **Noble, Nicholas et al**
**Kilburn & Strode LLP**
**Lacon London**
**84 Theobalds Road**
**London WC1X 8NL (GB)**

(56) References cited:
**WO-A1-2013/022035      WO-A1-2013/022035**
**JP-A- 2011 029 778      JP-A- 2011 029 778**
**JP-A- 2012 175 900      JP-A- 2012 175 900**

• **Takekazu Kato ET AL: "i-Energy Profile: Energy Informationization Profile by Smart-Tap Network", The IEICE TRANSACTIONS on Communications (Japanese Edition), 1 October 2011 (2011-10-01), pages 1232-1245, XP055276267, Retrieved from the Internet: URL:http://search.ieice.org/bin/pdf_link.php?category=B&lang=V&year=2011&fname=j94-b _10_1232&abst=j [retrieved on 2016-05-30]**
• **TAKEKAZU KATO ET AL.: 'i-Energy Profile: Energy Informationization Profile by Smart-Tap Network' THE TRANSACTIONS OF THE INSTITUTE OF ELECTRONICS, INFORMATION AND COMMUNICATION ENGINEERS vol. J94-B, no. 10, 01 October 2011, pages 1232 - 1245, XP055276267**

**Description**

<u>FIELD</u>

Embodiments of the present invention relate to an information processing device and method.

<u>BACKGROUND</u>

In introduction of a home energy management system (HEMS) for energy saving at home, power data for each device is required for visualization of power utilization. Visualization of power utilization is useful in encouraging a resident(s) to save energy, and is also useful in providing a service based on behavior analysis of the resident(s). For such visualization using power data, a device from which power data is obtained should be recognized.

Conventionally, the method and device for estimating a device from trunk power and estimating the power of the device have been proposed. On the other hand, there is a simpler technique for providing a power meter between a power receptacle and a power plug of the device to obtain information on the power of the device. Such a power meter is called a "smart plug." The smart plug communicates, for power visualization, with a home gateway of a HEMS placed inside a room to save measured power data in the home gateway or a server located outside the room.

When power measurement is performed for each power plug, if no proper correspondence is established among devices and power meters, obtained data cannot be used for visualization described above or device control. In order to avoid this situation, a resident(s) typically needs to establish a correspondence between a device and a power meter, and this becomes a burden on the resident(s). It is required that the burden on the resident(s) is reduced while a proper correspondence is established by the resident(s). Note that a correspondence between a power meter and a device as described herein indicates whether or not a correspondence between the name of a power meter and the name (type) of a device connected to the power meter is set.

i-Energy Profile: Energy Informationization Profile by Smart-Tap Network, the transactions of the institute of electronics information and communication engineers, by Takekazu KATO and Takashi MATSUYAMA describes that, in their research group, as a new energy management method to efficiently manage and operate various distributed energy generation / storage devices provided in homes / offices and even neighboring communities, the concept of "energy informationization" is proposed, and research and development mainly about power network are conducted. In the "energy informationization" for power energy, it aims to realize a new power management system that has not existed in the past, such as an on-demand power network system which not only performs remote control of distributed power sources /power storage devices and visualization of power consumption of individual home appliances, but also performs precise monitoring of power energy generated, consumed and distributed by power source, electrical equipment, power network through the estimation/control of the power flow on the power network, designates the supply destination for each different power source such as solar battery and storage battery, performs power flow control by origin, and further performs adaptive mediation of power demand and power supply. As an element technology of "energy informationization", smart-taps for performing detailed measurement /collection /control of voltage /current waveform in units of power source, electrical equipment and outlet, and the functional requirements (i-Energy Profile) of a smart-tap network for making those smart-taps cooperate and performing estimation and control of power flow are described.

<u>SUMMARY</u>

An invention is set out in the claims.

<u>BRIEF DESCRIPTION OF THE DRAWINGS</u>

FIG. 1 is an example system configuration diagram of a first approach;
FIG. 2 is a functional block diagram of an information processing device of the first approach;
FIG. 3 is a table of correspondence information between a power meter and a device;
FIG. 4 is a table of power data measured by the power meter;
FIG. 5 is a plot of examples of indices obtained by conversion of the power data;
FIG. 6 shows plots of an example of a device candidate estimation model according to a k-nearest neighbor algorithm;
FIG. 7 is a table of an example of device candidate estimation results according to the k-nearest neighbor algorithm;
FIG. 8 is a view of a display example at a visualizer of the first approach;
FIG. 9 is a graph of an example of a decision tree;
FIG. 10 is a plot of existence regions regarding the device indices obtained by decision tree analysis;

FIG. 11 is a flowchart of operation steps of the first approach;
FIG. 12 is a functional block diagram of an information processing device of a second approach;
FIG. 13 is a table of an example of reference data;
FIGS. 14A to 14F are plots of an example of a device candidate estimation model when the reference data is used;
FIG. 15 is a table of another example of the reference data;
FIGS. 16A to 16F are plots of another example of the device candidate estimation model when the reference data is used;
FIG. 17 is a view of a display example at a visualizer of a third approach; and
FIG. 18 is an example system configuration diagram of a

fourth approach.

DETAILED DESCRIPTION

According to one approach, an information processing device includes: a reader, an index calculator, an estimation processor and a visualizer. The reader reads correspondence information indicating types of devices measured by first power meters of a plurality of power meters, each power meter measuring power consumption of a corresponding one of the devices to acquire power data. The index calculator calculates an index from the power data. The estimation processor estimates candidates for a type of a device measured by a second power meter based on an index calculated from power data of the device measured by the second power meter, using training data which is the index calculated from the power data of the devices measured by the first power meters, the second power meter being included in the plurality of power meters and being different from the first power meters. The visualizer visualizes the device type candidates estimated by the estimation processor. Various embodiments of the present invention will be described below with reference to drawings.

(First Embodiment)

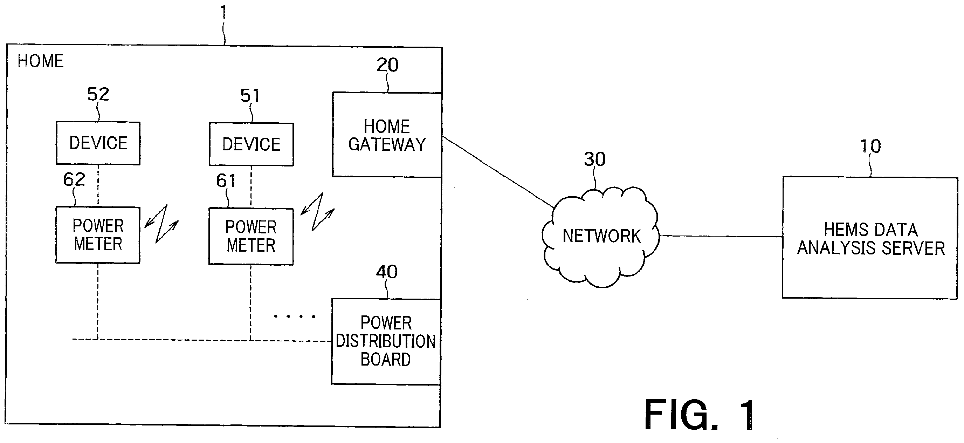

FIG. 1 illustrates an example system configuration diagram of a first embodiment of the present invention.
Suppose that a home gateway 20 is placed at a home 1 of a resident(s), and the home gateway 20 is connected to an external home energy management system (HEMS) data analysis server 10 via a network 30. At the home 1 of the resident(s), a HEMS is used, and the home gateway 20 may also serve as the HEMS.
At the home 1, a power line extending from a power distribution board 40 is connected to devices 51, 52 via power meters 61, 62. Each of the power meters 61, 62 is configured to measure power consumption of a corresponding one of the devices 51, 52. The home gateway 20 can wirelessly communicate with the power meters 61, 62 to transmit the power consumption of the devices 51, 52 to the HEMS data analysis server 10.
In this case, when a correspondence between the device 51 and the power meter 61 is established, the power of the device 51 is visualized by the HEMS data analysis server 10. Note that the correspondence does not necessarily specify the device corresponding to the power meter 61, and only a correspondence between the name of a power meter and the name (type) of a device may be recognized. The name (type) is, e.g., a TV or a washer. However, if no correspondence is established between the device 52 and the power meter 62, the power measured by the power meter 62 is visualized at the HEMS data analysis server 10, but the device (device type) from which such data is transmitted is unclear. Thus, it is essential for visualization using a power meter to establish a correspondence between a power meter and a device.
Typically, a correspondence between a device and a power meter is established by a resident(s). However, in the case of many power meters, establishment of a proper correspondence becomes a burden on the resident(s), and such a burden needs to be reduced. The information processing device of the embodiment of the present invention is for reducing this burden.

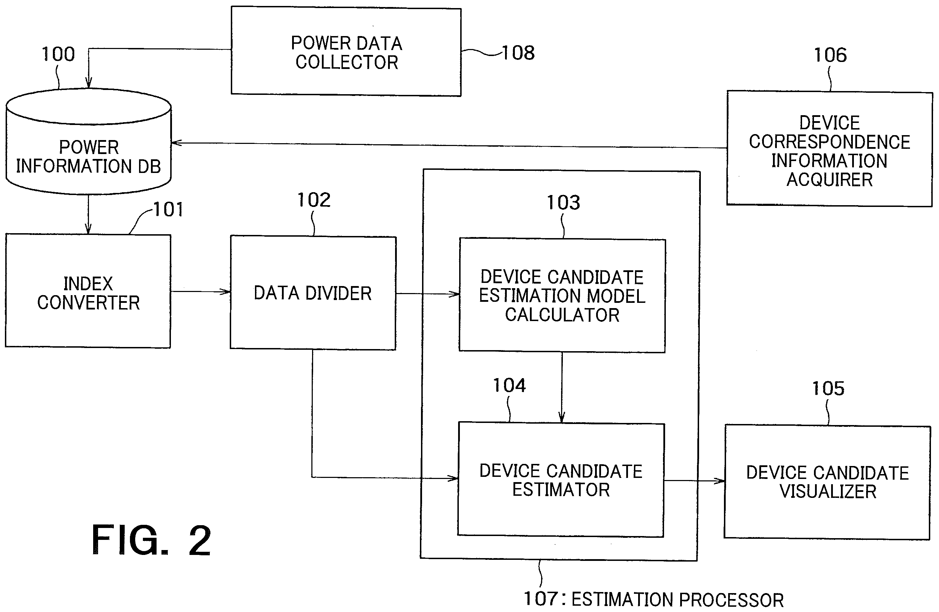

FIG. 2 is a functional block diagram of the information processing device of the embodiment of the present invention.
Suppose that in the present embodiment, the information processing device is implemented in the HEMS data analysis server 10. Note that the information processing device can be implemented in the home gateway 20. In this case, the home gateway 20 may be in a closed state at the home 1 without being connected to the network 30. Moreover, implementation of the information processing device of the embodiment of the present invention is not limited to the example system configuration of FIG. 1.
A power information DB 100 of FIG. 2 stores correspondence information among the power meters and the devices, and power data information measured by each power meter. Moreover, the power information DB 100 also stores various parameters required for calculation of indices described later.

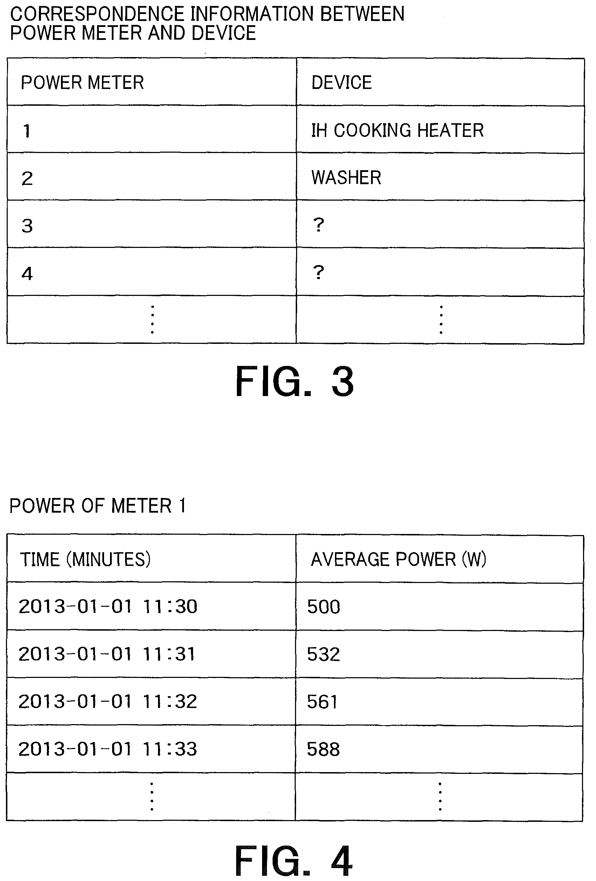

FIG. 3 shows an example of the correspondence information among the power meters and the devices, the information being stored in the power information DB 100. The correspondence between the power meter and the device as described herein indicates a correspondence between the name of a power meter and the name (type) of a device connected to the power meter. The device name may be a classification according to use applications, such as a washer or a TV, or a classification according to functions of the same application, such as a liquid crystal TV or a plasma TV. That is, the correspondence information is information specifying the name (type) of the device measured by the power meter.

In the case of the example of FIG. 3, a device connected to a power meter 1 is an IH cooking heater, and a device connected to a power meter 2 is a washer. Thus, a correspondence between the power meters 1, 2 and the devices is established. On the other hand, for power meters 3, 4, the names of devices connected thereto are unclear. Thus, no correspondence between the power meters 3, 4 and the devices is established.

FIG. 4 shows an example of power data stored in the power information DB 100 and measured by the power meter. FIG. 4 shows the power data of the meter 1 in chronological order. Power data of other meters are also stored in a similar format. FIG. 4 shows the example where one-minute power averages obtained by measurement of a power amount at one minute interval are used, but not only the one-minute power averages but also one-second power averages may be used as power data. Alternatively, instantaneous power at an interval of minute or second may be used. That is, any measurements obtained by the power meter may be used as power data.

A power meter whose correspondence to a device is established based on the correspondence information is hereinafter referred to as an "associated power meter," and a power meter whose correspondence to a device is not established is hereinafter referred to as a "non-associated power meter." Moreover, power data measured by an associated power meter is hereinafter referred to as "associated power data," and power data measured by a non-associated power meter is hereinafter referred to as "non-associated power data."

The correspondence information shown in FIG. 3 is set based on instruction data of the resident(s) acquired from the home gateway 20 of the home 1 by a device correspondence information acquirer 106 via the network 30. The power data measured by the power meter as shown in FIG. 4 is collected from the home gateway of the home 1 by a power data collector 108 via the network 30. In the case of implementing the information processing device of the present invention in the home gateway 20, the power data collector 108 collects power data by wireless or wire communication with each power meter, for example. Moreover, the device correspondence information acquirer 106 sets the correspondence information based on an instruction input from the resident(s).

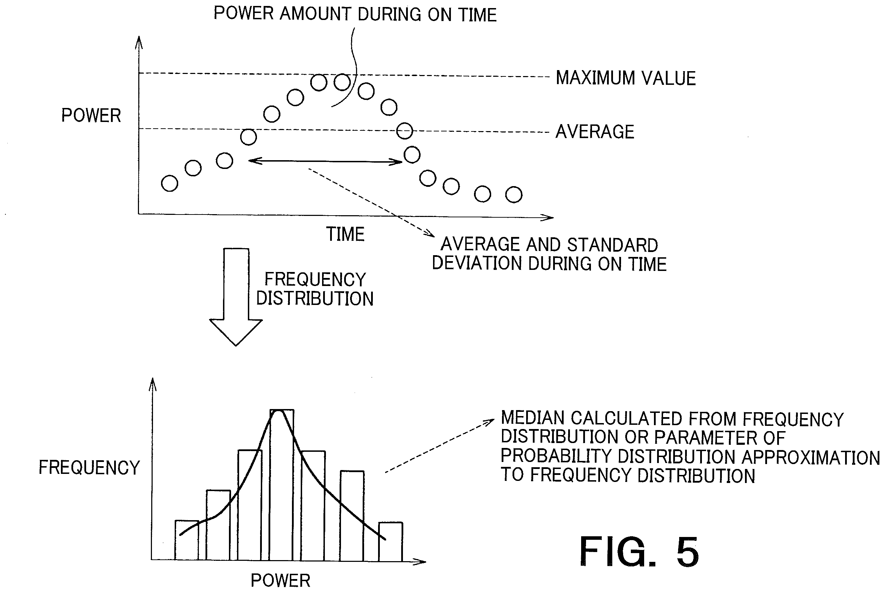

An index converter 101 of FIG. 2 includes a reader configured to read the correspondence information, power data etc. from the power information DB 100. The index converter 101 calculates indices (also called "features ") from the power data shown in FIG. 4. Examples of indices obtained from time-series power data include, as shown in FIG. 5, a maximum value, an average, and a power amount during a time period during which a device is operating (i.e., a power amount during an ON time period). These examples may further include a power amount during an OFF time period.

Other examples of the indices include, as shown in FIG. 5, a median in a frequency distribution generated from time-series power data, and a parameter in a probability distribution approximation to the frequency distribution.

Examples of the indices will be described below.

Suppose that power data of N days is shown, and power data of each day is shown as a separate data point. That is, power data of $n_1$-th day and power data of $n_2$-th day are taken as different data points. Data of a single day includes K points. Data from midnight of a certain day to midnight of the following day or data from 3 AM of a certain day to 3 AM of the following day may be taken as data of a single day. For example, when K = 1440, a data point is taken at one minute interval. Suppose that power data of an n-th day measured by a certain power meter is $p_{n,k}$ (n = 1, 2, ..., N, k = 1, 2, ..., K). In this case, a certain time period is expressed as $k = k_1$ and $k = k_2$, for example. When K = 1440 and a day starts at 3 AM, k = 1 indicates a data point at 3 AM in a certain day, and k = 1440 indicates data at 2:59 AM in the following day. Examples of time-series power indices during a time period from $k = k_1$ to $k = k_2$ in an n-th day will be described below.

A time-series power average $p_{mean}$ of the n-th day is, as an index example, obtained as follows:

[Expression 1]

$$p_{\mathrm{mean}} = \frac{1}{k_2 - k_1 + 1} \sum_{k=k_1}^{k_2} p_{n,k}$$

There is a median $p_{med}$ as an index similar to the average. The median $p_{med}$ is obtained as follows:

[Expression 2]

$$p_{\mathrm{med}} = \mathrm{median}(p_{n,k_1}, p_{n,k_1+1}, \ldots, p_{n,k_2})$$

In Expression 2, "median (...)" on the right side indicates that a median of values in parentheses is taken.

Moreover, a standard deviation $p_{std}$ and an interquartile range (IQR) $p_{IQR}$ are provided as indices indicating power variation. These indices are obtained as follows:

[Expression 3]

$$p_{\mathrm{std}} = \sqrt{\frac{1}{k_2 - k_1} \sum_{k=k_1}^{k_2} (p_{n,k} - p_{\mathrm{mean}})^2}$$

[Expression 4]

$$p_{\mathrm{IQR}} = p_{n,75\%} - p_{n,25\%}$$

In the above-described expressions, "$P_{mean}$" is obtained by Expression 2, and "$p_{n,25\%}$" and "$p_{n,75\%}$" respectively indicate a 25% point and a 75% point when values of $p_{n,k}$ from $k = k_1$ to $k = k_2$ are arranged in ascending order.

Suppose that the above-described "N," "K," "$k_1$," and "$k_2$" are registered in the power information DB 100.

When a single day includes a plurality of ON time periods, indices such as a maximum value, an average, a median, a standard deviation, and an IQR in each ON time period can be taken. Suppose that the ON time periods are represented by $t_{n,k}$ ($n = 1, 2, \ldots, N$, $k = k_1, k_2, \ldots, k_L$). Moreover, "$k_1, k_2, \ldots, k_L$" are points each indicating a time at which a device is turned ON. Examples of the method for calculating an ON time include the method for taking, as an ON time, a time when a value of power less than a preset threshold $p_{th}$ at a previous time point reaches equal to or higher than the threshold $p_{th}$. The method for calculating the ON time is not limited to the method described herein. A time at which a device is turned OFF can be similarly calculated. With the ON time and the OFF time described above, the ON time period can be specified. Calculation examples of the maximum value, the average, the median, the standard deviation, and the IQR in the ON time period will be described below.

The maximum value in the time period in which the device is ON is obtained as follows:

[Expression 5]

$$t_{\mathrm{max}} = \max(t_{n,k_1}, t_{n,k_2}, \ldots, t_{n,k_L})$$

The average in the time period in which the device is ON is obtained as follows:

[Expression 6]

$$t_{\mathrm{mean}} = \frac{1}{L} \sum_{k=k_1}^{k_L} t_{n,l}$$

The median in the time period in which the device is ON is obtained as follows:

[Expression 7]

$$t_{\mathrm{med}} = \mathrm{median}\left(t_{n,k_1}, t_{n,k_2}, \ldots, t_{n,k_L}\right)$$

The standard deviation in the time period in which the device is ON is obtained as follows:

[Expression 8]

$$t_{\mathrm{std}} = \sqrt{\frac{1}{L-1} \sum_{k=k_1}^{k_L} \left(t_{n,k} - t_{\mathrm{mean}}\right)^2}$$

The IQR in the time period in which the device is ON is obtained as follows:

[Expression 9]

$$t_{\mathrm{IQR}} = t_{n,75\%} - t_{n,25\%}$$

The definitions of "max (...)" and "median (...)" are similar to that in calculation of "$p_{n,k}$." Moreover, "$t_{n,25\%}$" and "$t_{n,75\%}$" respectively indicate a 25% point and a 75% point when values of $t_{n,k}$ during $k = k_1, k_2, ..., k_L$ are arranged in ascending order. Suppose that in addition to "N," "K," "$k_1$," and "$k_2$," "$p_{th}$" is also registered in the power information DB 100.

Although the above-described indices are used, the indices used at the index converter 101 are not limited to those described herein. As long as calculation can be made based on power data measured by a power meter and time information obtained when the power data is acquired, any indices may be used. Moreover, a single index or a plurality of indices may be used. Although daily data is taken as a separate data point in connection with the above-described index examples, power data may be delimited at a weekly interval or a monthly interval, and such delimited points may be taken as different data points.

A data divider 102 is configured to divide index values of power data calculated by the index converter 101 into an index value of associated power data and an index value of non-associated power data. The data divider 102 inputs the index value of the associated power data to a device candidate estimation model calculator 103 of an estimation processor 107. Moreover, the data divider 102 inputs the index value of the non-associated power data to a device candidate estimator 104 of the estimation processor 107.

The estimation processor 107 is configured to estimate, using the index value of the associated power data as training data, device candidates, more specifically the names (types) of device candidates, connected to a non-associated power meter from the index value of the non-associated power data. Device candidate estimation described later is for estimating the name (type) of a device connected to a power meter targeted for estimation, and a device candidate is a candidate for the name (type) of the device connected to the power meter.

The device candidate estimation model calculator 103 of the estimation processor 107 is configured to calculate an estimation model used at the device candidate estimator 104 based on the index value of the associated power data. The device candidate estimator 104 is configured to estimate the device candidates from the index value of the non-associated power data based on the estimation model.

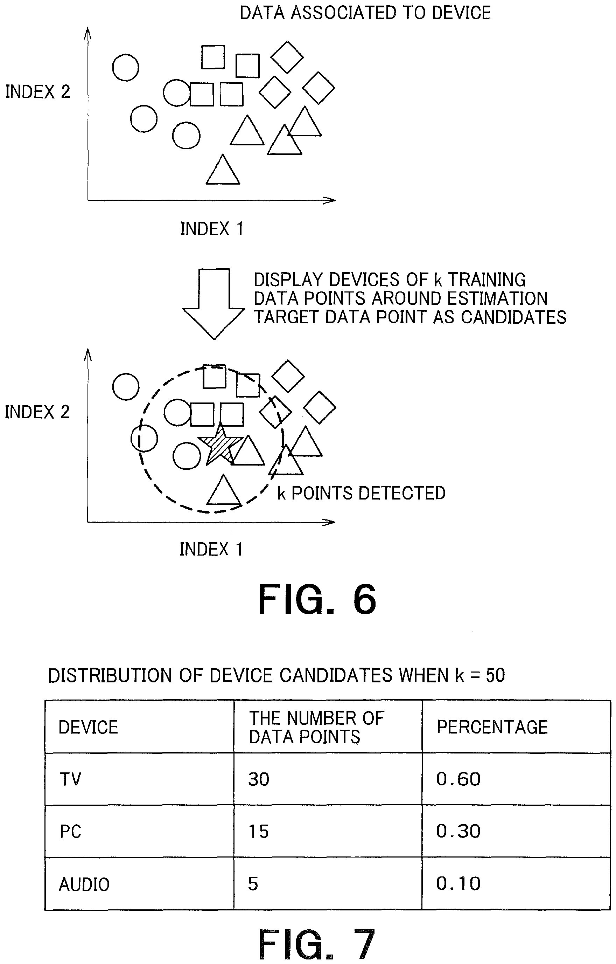

FIG. 6 shows an example where a machine learning method called a "k-nearest neighbor algorithm" is applied to estimate device candidates connected to a non-associated power meter. FIG. 6 shows the example in the case of calculating two indices 1, 2 at the index converter 101. Based on the values of the indices calculated at the index converter 101, the upper part of FIG. 6 is shown as a result of plotting data points in a coordinate system in which each index is taken as an axis. In the upper part of FIG. 6, data points from the associated power meter are plotted based on the index values. Such processing is performed at the device candidate estimation model calculator 103.

In this case, the data point (indicated by a black star in the lower part of FIG. 6B) from the non-associated power meter is plotted in the coordinate system based on the index values. Of data points of an associated power meter, k data points closest to the data point of the non-associated power meter are identified. After the closest k data points are identified, the identified data points are aggregated according to devices to generate a distribution indicating the number of data points for each device. Moreover, the proportion of the number of data points may be calculated for each device from such a distribution. The distribution or proportion for each device may be obtained as a device candidate, a device(s) with the highest number of data points or the highest proportion may be taken as a device candidate(s), or a device(s) with the number of data points or the proportion equal to or higher than a threshold may be taken as a device candidate(s). Such processing corresponds to device candidate estimation at the device candidate estimator 104.

FIG. 7 shows a distribution generated in such a manner that when k = 50 in the example of FIGS. 6A and 6B, closest 50 data points are identified and aggregated according to devices. Since 30 points indicate a TV, 15 points indicate a PC, and five points indicate an audio, the proportion of the TV is 0.60, the proportion of the PC is 0.30, and the proportion of the audio is 0.10.

A visualizer 105 visualizes, for a resident(s), device candidates based on the estimation results of the device candidate estimator 104. For example, information on the device candidates is displayed on a display.

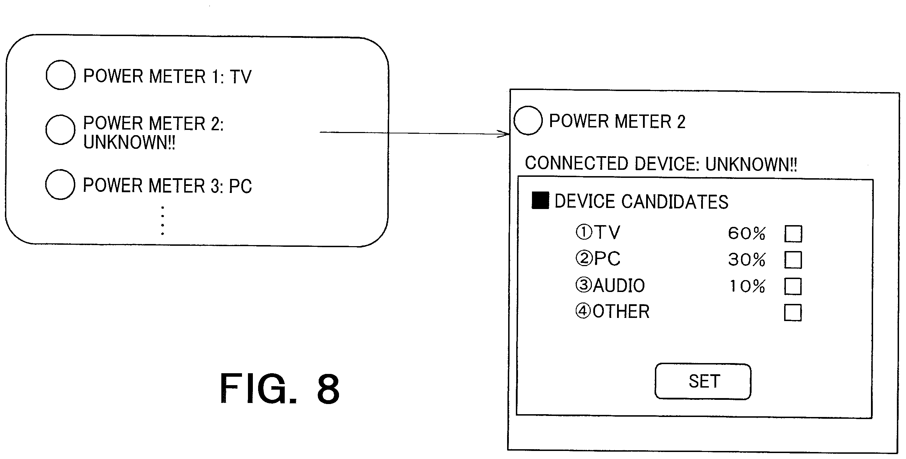

FIG. 8 illustrates an example of visualization of the visualizer 105 in the example shown in FIG. 7. In FIG. 8, a non-associated power meter is a power meter 2. It has been recognized that, e.g., power meters 1, 3 are connected respectively to the TV and the PC. The candidates for the device connected to the power meter 2 include the TV, the PC, and the audio, and the proportions of the TV, the PC, and the audio are displayed as 60%, 30%, and 10%, respectively. As described above, since the device candidate estimation results are visualized for the resident(s), a burden of the resident(s) setting the name of a device connected to a power meter is reduced.

When the name of the device connected to the non-associated power meter is set by the resident(s), the device correspondence information acquirer 106 acquires such information to reflect the correspondence relationship in the power information DB 100 (see FIG. 3). For example, the resident(s) selects and determines, on a visualized image illustrated in FIG. 8, a device from the device candidates, and then, the device correspondence information acquirer 106 receives the setting made by the resident(s). Power data from the power meter whose correspondence to the device has been established as described above can be used to calculate a candidate(s) for a device connected to a power meter remaining non-associated with a device or to a newly-added power meter. By updating the power information DB 100 as described above, the accuracy of device candidate estimation is enhanced.

Although FIGS. 6A and 6B show the estimation method in the case of using two indices 1, 2, the number of indices is not limited to two as described above.

FIGS. 6A, 6B, and 7 show the example employing the machine learning manner called the "k-nearest neighbor algorithm," but the device candidate estimation model and the device candidate estimation made based on the device candidate estimation model are not limited to those in the above-described example. For example, the following method may be employed: decision tree analysis is applied to index values calculated from associated power data to estimate an existence region of each device, and then, a device candidate(s) is estimated from a region to which index values calculated from non-associated power data belong. In this case, the device candidate estimation model calculator 103 calculates a decision tree as a device candidate estimation model, and the decision tree is used to estimate the device candidate(s) at the device candidate estimator 104.

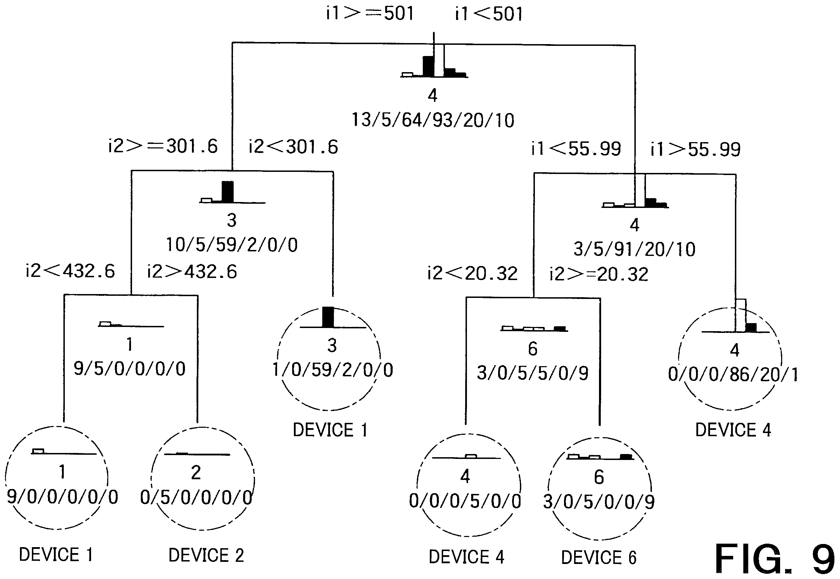

FIG. 9 shows an example of a decision tree generated using two indices i1, i2. FIG. 9 shows the case where there are six associated power meters and devices connected respectively to the associated power meters are devices 1 to 6. In FIG. 9, "i1>=501 i1<501" at an uppermost branched point of the tree indicates that data is divided at an index i1 having a value of 501. Moreover, "13/5/64/93/20/10" at the uppermost branched point indicates a data distribution before the data is divided at an index i1 having a value of 501, and indicates the number of data points for the devices 1 to 6 in the order from the left side. A digit "4" above "13/5/64/93/20/10" indicates that a device with the highest number of data points is the device 4. Moreover, a bar graph shows the data distribution. Indications at other branched points and terminal ends in FIG. 9 are similar to those described above. Each terminal end of the tree in FIG. 9 indicates a region of the indexes selected through branched points existing down to the terminal end, and classification results corresponding to such a region. The first terminal end from the left side in FIG. 9 indicates a region classified as the device 1.

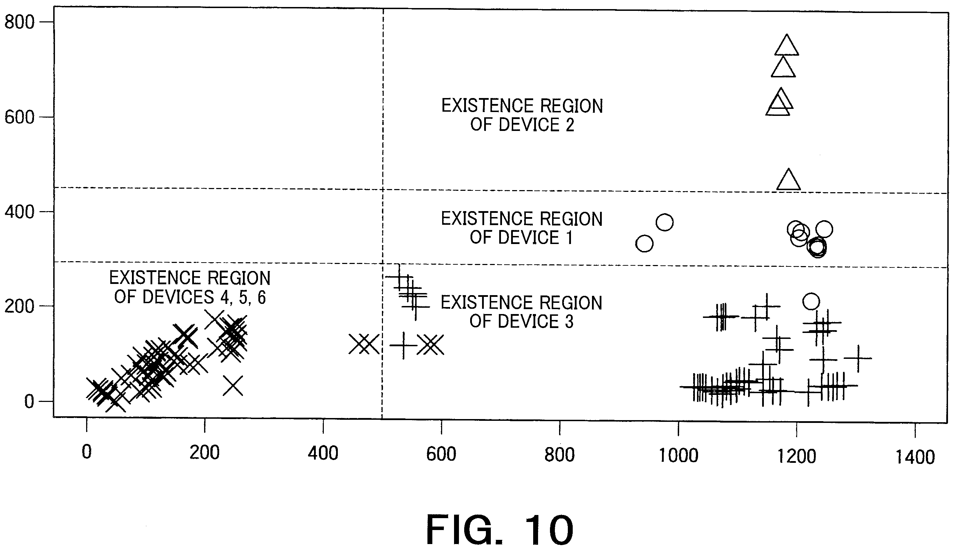

Such results show that the tree is branched into two groups consisting of a group of (the devices 1, 2, 3) and a group of (the devices 4, 5, 6) on the basis of whether the index i1 is equal to or higher than 501 or is lower than 501. Moreover, in the case where the index i1 is equal to or higher than 501, the tree can be further branched into a group of (the devices 1, 2) and a group of the device 3 on the basis of whether the index i2 is equal to or higher than 301.6 or is lower than 301.6. In the case where the index i1 is equal to or higher than 501 and the index i2 is equal to or higher than 301.6, the tree can be further branched into the device 1 and the device 2 on the basis of whether the index i2 is equal to or higher than 432.6 or is lower than 432.6. FIG. 10 intuitively shows each region to which a corresponding one of six types of devices belongs, the index i1 being taken as the horizontal axis and the index i2 being taken as the vertical axis. A device candidate varies according to the region of FIG. 10 to which data from a non-associated power meter belongs. The region to which such data belongs may be determined in such a manner that the data is classified based on the decision tree shown in FIG. 9 to take, as the region to which the data belongs, a device region corresponding to a classified terminal node.

In the existence regions of the devices 1, 2, no data of other devices exits (see terminal nodes indicating the devices 1, 2 in FIG. 9). Thus, in the case of being classified as one of the regions of the devices 1, 2, the type of device 1 or 2 itself can be provided as a connected device. That is, in the case of classifying data as data belonging to the region corresponding to the device 1 or the device 2, the existence probability of the device 1 or the device 2 may be displayed as 100% on the visualizer 105 of FIG. 8.

On the other hand, in the case of classifying data as data belonging to the existence regions of the device 3 and the respective devices 4, 5, 6, the existence probability of each device included in the respective regions corresponding to the device 3 and the respective devices 4, 5, 6 may be displayed. For example, based on the results shown as the device 3 at the terminal node in FIG. 9, the following display may be made: Device 1: 1.6% (= 1/(1 + 59 + 2)); Device 3: 95% (= 59/(1 + 59 + 2)); and Device 4: 3.2% (= 2/(1 + 59 + 2)).

Alternatively, analysis using clustering may be used as a method other than decision tree analysis. For example, in the case where the data points of each device are scattered as shown in FIG. 10, clustering may be performed to generate a plurality of cluster regions to specify device candidates based on the cluster region to which target data belongs. The number of data points for each device in the cluster region to which the target data belongs may be aggregated, and then, the probability for each device may be provided as a candidate probability.

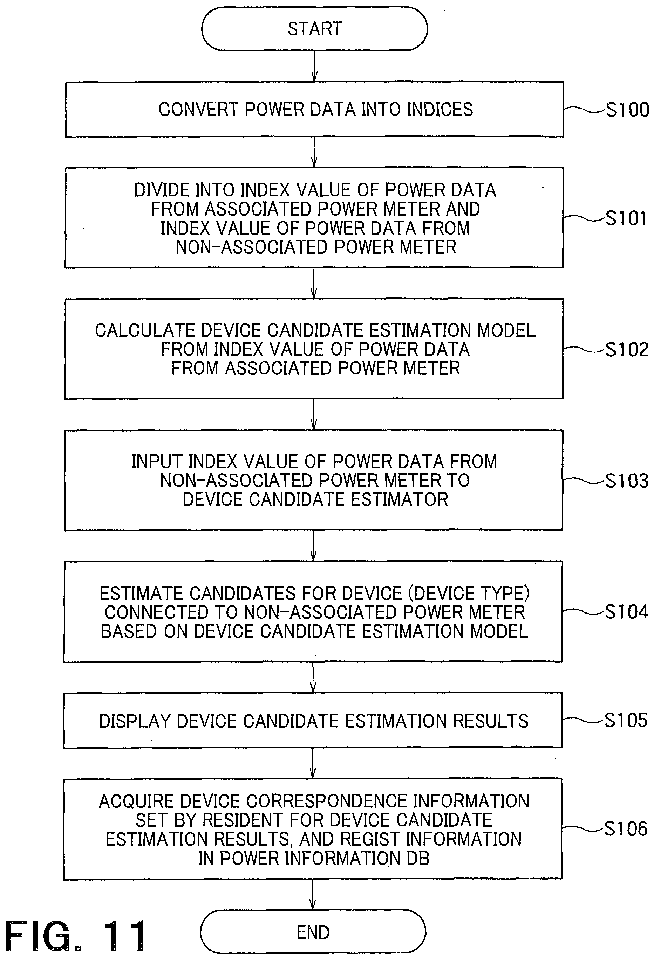

FIG. 11 is a flowchart of operation steps of a device candidate calculation device of the embodiment of the present invention. The operation steps of the present device of the embodiment of the present invention will be described below according to the steps of the flowchart.

At step S100, power data measured by each power meter is converted into indices as described above with reference to FIG. 5.

At step S101, index values of the power data converted at step S100 are, based on the correspondence information exemplified in FIG. 3, divided into an index value of associated power data and an index value of non-associated power data.

At step S102, a device candidate estimation model is calculated from the index value of the associated power data.

At step S103, the index value of the non-associated power data is applied to the device candidate estimation model calculated at step S102 to estimate candidates for a device, more specifically a device name (type), connected to the non-associated power meter (step S104).

At step S105, the device candidates estimated at step S104 are displayed.

At step S106, in the case where a resident(s) sets correspondence information between a device and a power meter based on the displayed device candidates, such information is acquired and registered in the power information DB 100. In the case where the resident(s) sets no device information, such information indicating that no device information is set is registered in the power information DB 100.

The operation of the flowchart described above is performed at a certain interval to display the device candidates to the resident(s). Thus, it is expected that the number of associated power meters increases. Moreover, updating of the power information DB 100 is repeated, and therefore, the accuracy of the device candidate estimation model is enhanced.

According to the present embodiment described above, when the resident(s) sets a correspondence between a device and a power meter, candidates for a device corresponding to a non-associated power meter is estimated based on power data of a device whose correspondence to a power meter has been already established, and then, is provided to the resident(s). In this manner, a burden of the resident(s) setting the correspondence between the device and the power meter can be reduced.

(Second Embodiment)

In the first embodiment, device candidate estimation is made using only power data measured by the associated power meters. In a second embodiment, device candidate estimation is made using both of the above-described power data and virtually-generated power data.

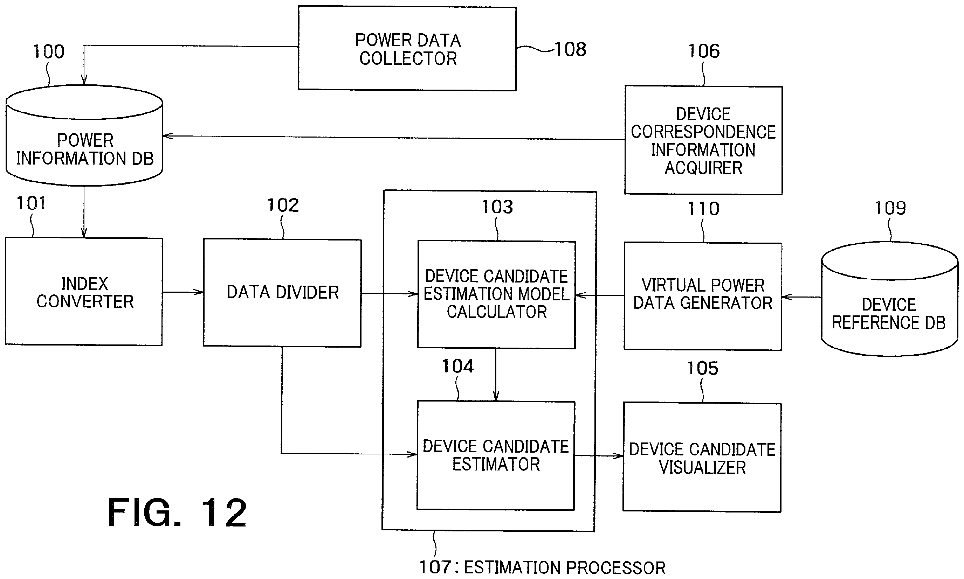

FIG. 12 is a functional block diagram of the second embodiment. A device reference DB 109 and a virtual power data generator 110 are added to the configuration of the first embodiment.

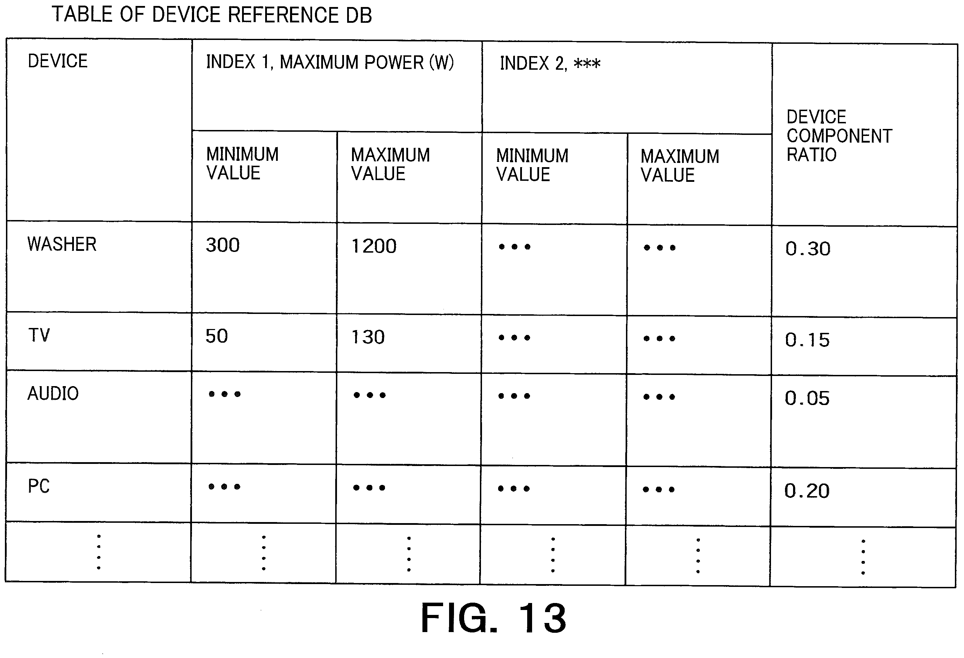

FIG. 13 shows an example of the device reference DB 109. The device reference DB 109 contains information (sampling conditions) on minimum and maximum values of each index according to devices. With such information, the number (amount) of device power data measured by associated power meters can be virtually increased.

In FIG. 13, a component ratio column for each device includes a component ratio showing the percentage of each device in virtually-generated power data.

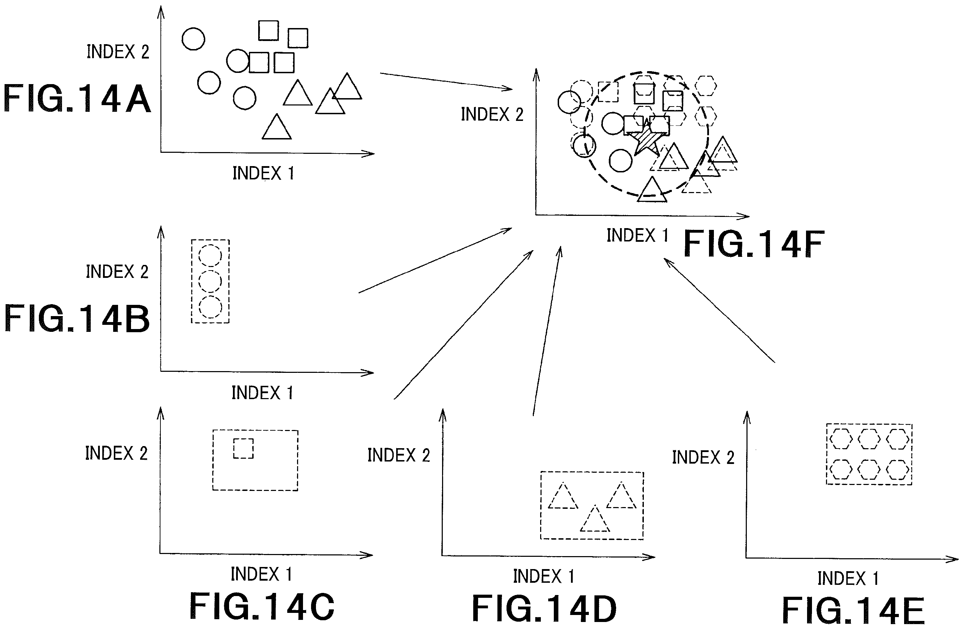

FIGS. 14A to 14F show an example where sample points of virtual power data are, based on random numbers, generated from information (minimum and maximum values) on each index of devices registered in the device reference DB 109 to perform device candidate estimation according to the k-nearest neighbor algorithm described with reference to FIG. 6.

FIGS. 14B, 14C, 14D, and 14E each show index values of virtual power data generated for a power meter (associated power meter) of each device by sampling. FIG. 14A shows index values of power data actually measured by the power meter (associated power meter) of each device. FIG. 14F shows the state in which FIGS. 14B to 14E are added to FIG. 14A. A black star indicates a data point from a non-associated power meter.

In the case where power data corresponding to devices is not sufficiently provided, virtual power data is generated by the virtual power data generator 110 based on the device reference DB 109, and therefore, the amount of power data can be increased.

Such virtual power data is, together with associated power data, used at the device candidate estimation model calculator 103, and as a result, the accuracy of device candidate estimation can be enhanced for non-associated power data. The accuracy of device candidate estimation can be further enhanced by periodical updating of the device reference DB 109.

In the example of the device reference DB 109 shown in FIG. 13, virtual device power data is generated (sampled) from a rectangular uniform distribution. However, such data can be generated from a more flexible distribution such as a multidimensional mixed normal distribution.

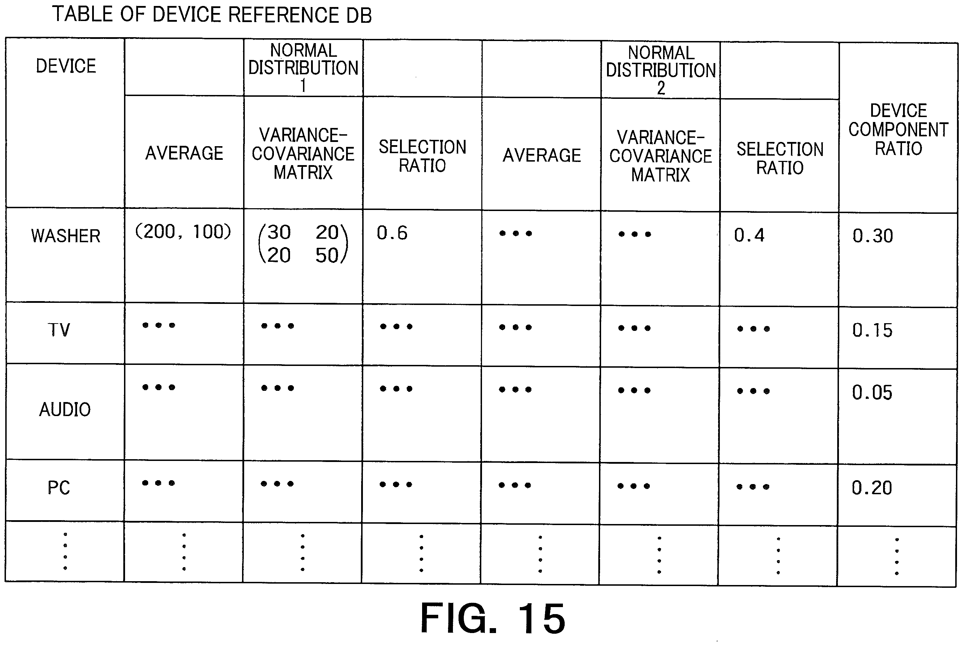

FIG. 15 is an example of a device reference DB based on a mixed normal distribution. Suppose that in this example, virtual power data for each device is generated by two normal distributions. FIG. 15 shows the following sampling conditions: for the normal distribution of indexes, an average vector (average) and a variance-covariance matrix for indexes; for the mixed normal distribution, a selection ratio; and for each device, a component ratio. The component ratio is similar to that described above. The selection ratio is a weight (coefficient) in synthesizing of the normal distributions. Components of the average vector are averages of indices 1, 2.

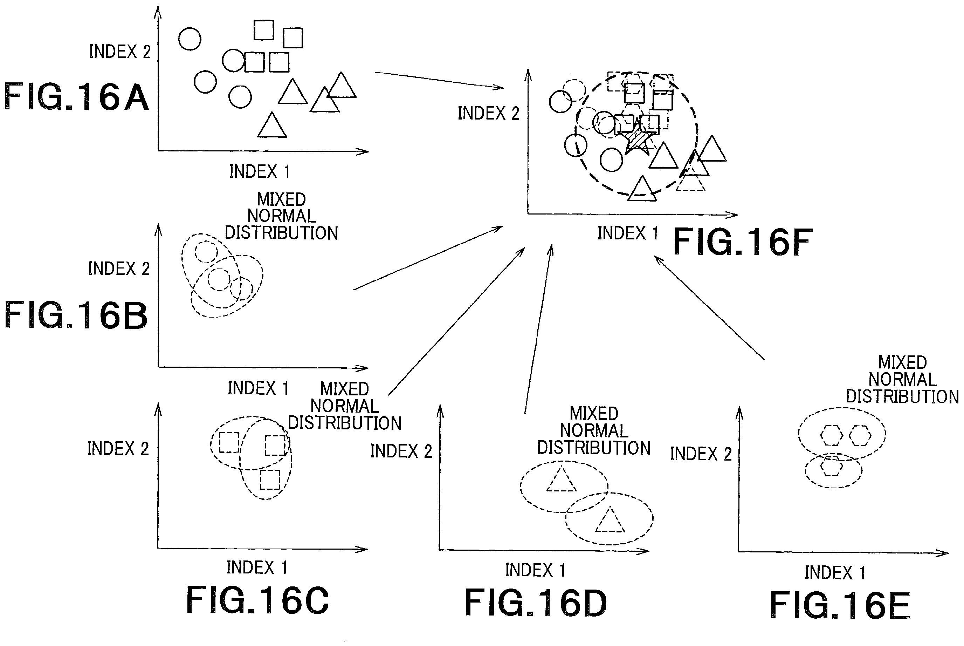

FIGS. 16A to 16F show an example where sample points of virtual power data are, based on random numbers, generated from device information (an average vector, a variance-covariance matrix, and a selection ratio in a mixed normal distribution) stored in the device reference DB 109 to perform device type candidate estimation according to the k-nearest neighbor algorithm described with reference to FIG. 6.

FIGS. 16B, 16C, 16D, and 16E each show index values of virtual power data generated for a power meter (associated power meter) of each device by sampling. FIG. 16A shows index values of power data actually measured by the power meter (associated power meter) of each device. FIG. 16F shows the state in which FIGS. 16B to 16E are added to FIG. 16A. A black star indicates a data point from a non-associated power meter.

In this example, two multidimensional normal distributions are used. However, the number of normal distributions for generation of virtual power data of each device is not limited to two. Virtual power data may be generated only from a single normal distribution at a certain device, whereas virtual power data may be generated from a mixed distribution of three normal distributions at another device.

Although two examples of the device reference DB 109 have been described above, device information stored in the device reference DB 109 is not limited to those described herein. Moreover, the manner for generating virtual power data by the virtual power data generator 110 is not limited to those described herein.

(Third Embodiment)

In a third embodiment, even when a resident(s) changes a device connected to an associated power meter to another device, such a change can be calculated. Since a block diagram of the present embodiment is similar to FIG. 2 or 12, description thereof will not be repeated.

In the first or second embodiment, power data from a non-associated power meter is targeted for estimation. In the present embodiment, power data from one selected from associated power meters is targeted for estimation. A data divider 102 divides index values into an index value of the selected power meter and an index value(s) of other power meter(s). The index value of the selected power meter is output to a device candidate estimator 104, and the index value(s) of other power meter(s) is output to a device candidate estimation model calculator 103. In this manner, candidates for a device connected to the selected power meter are estimated at the device candidate estimator 104. The device candidate estimator 104 may determine whether or not a first one of the device candidates and an actually-registered device match with each other. Information on the device candidate and the actually-registered device is displayed on a visualizer 105. When these devices do not match with each other, the device candidate estimator 104 may output a message indicating a high probability of a device change or a message requesting the resident(s) for a device change.

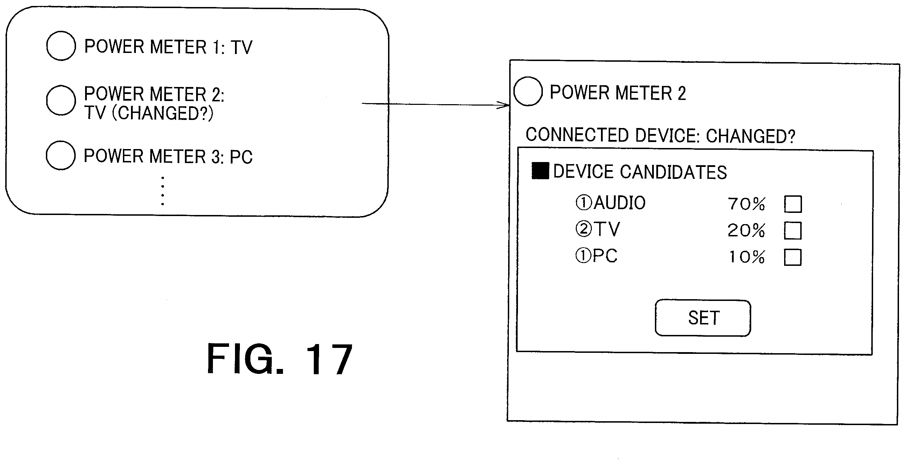

FIG. 17 illustrates an example of visualization by the visualizer 105. Such display shows the possibility that a connected device has been changed. An actually-registered device is a TV, and a first candidate shown in estimation results is an audio. Moreover, candidates for devices which might be connected to a target power meter are visualized in a format similar to that of FIG. 8. The possibility of a change in device connected to a power meter and device candidate estimation results after a device change are visualized for the resident(s) as illustrated in FIG. 17, and therefore, a burden of the resident(s) re-setting the name of the device connected to the power meter is reduced. Moreover, the possibility that the resident(s) fails to change the connected device setting can be reduced.

(Fourth Embodiment)

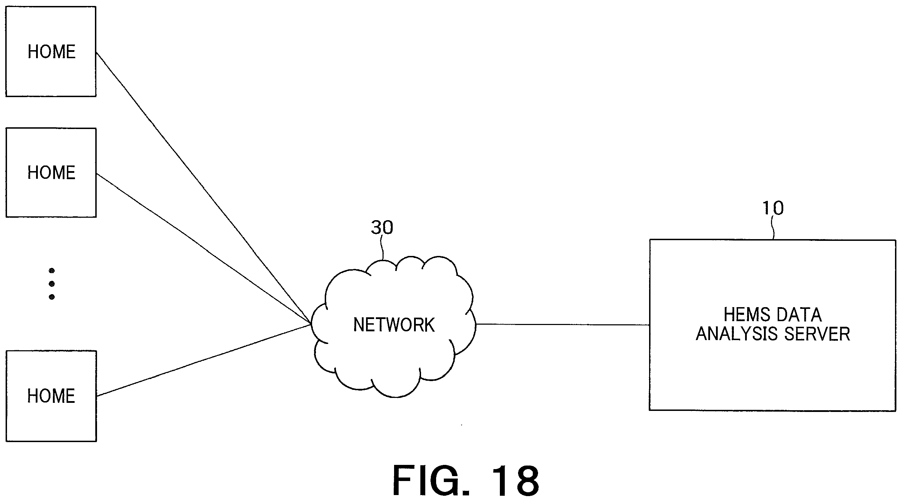

The case where device candidates are estimated for the single residential home as illustrated in FIG. 1 has been described in the above-described embodiments. However, device candidates can be estimated for power meters of a plurality of homes as illustrated in FIG. 18. In this case, each function of FIGS. 2 and 12 can be implemented across the homes without changing the functional block diagrams of FIGS. 2 and 12. A HEMS data analysis server 10 collects power data, correspondence information, etc. from the homes to perform processing similar to that described above. Since estimation is made using information from the homes, the number of samples increases. Thus, estimation with a higher accuracy can be expected.

Each of the above-described embodiments may be implemented by a single computer or a plurality of computers. For example, each embodiment may be implemented as follows: the power information DB 100 is used as a database server, and the index converter 101, the data divider 102, the device candidate estimation model calculator 103, the device candidate estimator 104, the visualizer 105, and the device correspondence information acquirer are implemented on a single computer to call for data from the server as needed.

Each embodiment as described above may also be realized using a general-purpose computer device as basic hardware. That is, each function block in each embodiment can be realized by causing a processor mounted in the above general-purpose computer device to execute a program. In this case, the embodiment may be realized by installing the above described program in the computer device beforehand or may be realized by storing the program in a storage medium such as a CD-ROM or distributing the above described program over a network and installing this program in the computer device as appropriate. Furthermore, the database or the storage in each embodiment may also be realized using a memory device or hard disk incorporated in or externally added to the above described computer device or a storage medium such as CD-R, CD-RW, DVD-RAM, DVD-R as appropriate.

While certain embodiments have been described, these embodiments have been presented by way of example only, and are not intended to limit the scope of the inventions. Indeed, the apparatuses described herein may be embodied in a variety of other forms; furthermore various omissions, substitutions and changes in the form of the apparatuses described herein may be made. The accompanying claims and their equivalents are intended to cover such forms or modifications as would fall within the scope of the inventions.

**Claims**

1.   An information processing device comprising:

a reader (101) configured to read correspondence information indicating device types of devices measured by first power meters of a plurality of power meters, the plurality of power meters measuring power consumption of devices corresponding to the plurality of power meters to acquire power data of the plurality of devices;
an index calculator (101) configured to calculate an index from the power data;
an estimation processor (107) configured to estimate a plurality of candidates for a device type of a device measured by a second power meter and probabilities at which the candidates are connected to the second power meter based on an index calculated from power data of the device measured by the second power meter and training data which is indices calculated from the power data of the devices measured by the first power meters, the second power meter being included in the plurality of power meters and being different from the first power meters; and
a visualizer (105) configured to visualize the plurality of candidates for the device type and the probabilities at which the candidates are connected to the second power meter.

2.   The information processing device of claim 1, further comprising:
an information acquirer (106) configured to receive a setting instruction designating the device type measured by the second power meter and set the device type of the device measured by the second power meter in the correspondence information based on the setting instruction.

3.   The information processing device of claim 2, wherein
the estimation processor specifies, using indices calculated from device power data measured by some of the first power meters as training data, a candidate for the device type of the device measured by a third power meter based on an index calculated from power data of the device measured by the third power meter, the third power meter being selected from remaining power meters of the first power meters, and
the visualizer visualizes the device type, of the device connected to the third power meter specified by the correspondence information, and the candidate of the device type specified by the estimation processor.

4. The information processing device of claim 3, wherein
the information acquirer receives a change instruction designating the device type of the device measured by the third power meter and updates the correspondence information so as to change the device type of the device measured by the third power meter based on the change instruction.

5. The information processing device of any one of claims 1 to 4, wherein
the estimation processor samples, according to a sampling condition pre-defined for the devices measured by the first power meters, the power data of the devices measured by the first power meters and further uses indices calculated from the sampled power data as the training data.

6. The information processing device of claim 5, wherein
the sampling condition sets minimum and maximum value ranges of the power data of the devices.

7. The information processing device of claim 5, wherein
the sampling condition sets a probability distribution for the power data of the devices to follow.

8. The information processing device of claim 6 or 7, wherein
the sampling condition sets a ratio of the number of samples among the devices corresponding to the first power meters.

9. The information processing device of any one of claims 1 to 8, wherein
the estimation processor specifies, for the power data of the device measured by the second power meter, k points of closest power data among the power data of the devices measured by the first power meters with respect to a distance based on the index,
aggregates the specified k points of power data per the device measured by the first power meters to obtain the number of points of power data per the device, and
estimates, based on the number of points of power data per the device, the plurality of candidates for a device type of the device measured by the second power meter and the probabilities at which the candidates are connected to the second power meter.

10. The information processing device of claims 1 to 8, wherein
the estimation processor generates a decision tree for specifying one of regions separated by values of an index based on the training data,

the estimation processor specifies a region of the index calculated from the device power data measured by the second power meter based on the decision tree,
the estimation processor specifies the number of indices calculated per the device from the power data of the devices measured by the first power meters in the specified region, and
the estimation processor estimates the plurality of candidates for a device type of the device measured by a second power meter and the probabilities at which the candidates are connected to the second power meter, based on the number of indices calculated per the device in the specified region.

11. An information processing method comprising:

reading-in (101) correspondence information indicating types of device devices measured by first power meters of a plurality of power meters, the plurality of power meters measuring power consumption of devices corresponding to the plurality of power meters to acquire power data of the plurality of devices;
calculating (101) an index from the power data;
estimating (107) a plurality of candidates for a device type of the device measured by a second power meter and probabilities at which the candidates are connected to the second power meter based on an index calculated from power data of the device measured by the second power meter and training data which is indices calculated from the power data of the devices measured by the first power meters, the second power meter being included in the plurality of power meters and being different from the first power meters; and
visualizing (105) the plurality of candidates for the device type and the probabilities at which the candidates are connected to the second power meter.

**Patentansprüche**

1. Informations-Verarbeitungsvorrichtung, umfassend:

   einen Leser (101), der konfiguriert ist, Entsprechungsinformation, die Vorrichtungstypen von Vorrichtungen, die durch erste Strommesser einer Vielzahl von Strommessern gemessen sind, angibt, auszulesen, wobei die Vielzahl von Strommessern den Stromverbrauch von Vorrichtungen misst, die der Vielzahl von Strommessern entsprechen, um Stromdaten der Vielzahl von Vorrichtungen zu ermitteln;
   einen Indexrechner (101), der konfiguriert ist, einen Index aus den Stromdaten zu berechnen;
   einen Schätzprozessor (107), der konfiguriert ist, eine Vielzahl von Kandidaten für einen Vorrichtungstyp einer Vorrichtung abzuschätzen, die durch einen zweiten Strommesser gemessen sind, und Wahrscheinlichkeiten, mit welchen die Kandidaten mit dem zweiten Strommesser verbunden sind, basierend auf einem Index, der berechnet wird aus Stromdaten der Vorrichtung, die durch den zweiten Strommesser gemessen sind, und Trainingsdaten, die Indizes sind, die aus den Stromdaten der durch die ersten Strommesser gemessenen Vorrichtungen berechnet werden, wobei der zweite Strommesser in der Vielzahl von Strommessern enthalten ist und sich von den ersten Strommessern unterscheidet; und
   einen Visualisierer (105), der konfiguriert ist, die Vielzahl von Kandidaten für den Vorrichtungstyp und die Wahrscheinlichkeiten, mit welchen die Kandidaten mit dem zweiten Strommesser verbunden sind, zu visualisieren.

2. Informations-Verarbeitungsvorrichtung nach Anspruch 1, weiter umfassend:
   einen Informationserfasser (106), der konfiguriert ist, eine Einstellanweisung zu empfangen, welche den durch den zweiten Strommesser gemessenen Vorrichtungstyp bezeichnet, und den Vorrichtungstyp der durch den zweiten Strommesser gemessenen Vorrichtung in der Korrespondenzinformation einzustellen, basierend auf der Einstellanweisung.

3. Informationsverarbeitungsvorrichtung nach Anspruch 2, wobei
   der Schätzprozessor unter Verwendung von Indizes, die aus, durch einige der ersten Strommesser als Trainingsdaten gemessenen Vorrichtungsstromdaten einen Kandidaten für den Vorrichtungstyp der Vorrichtung, die durch einen dritten Strommesser gemessen wird, basierend auf einem Index, der aus Stromdaten der Vorrichtung, gemessen durch den dritten Strommesser, berechnet wird, spezifiziert, wobei der dritte Strommesser aus verbleibenden Strommessern der ersten Strommesser ausgewählt wird, und
   der Visualisierer den Vorrichtungstyp der mit dem dritten, durch die Korrespondenzinformation spezifizierten Strommesser verbundenen Vorrichtung und den Kandidaten der durch den Schätzprozessor spezifizierten Vorrichtungstyp visualisiert.

4. Informations-Verarbeitungsvorrichtung nach Anspruch 3, wobei
   der Informationserfasser eine Änderungsanweisung empfängt, welche den Vorrichtungstyp der durch den dritten Strommesser gemessenen Vorrichtung bezeichnet, und die Korrespondenzinformation aktualisiert, um so den Vorrichtungstyp der durch den dritten Strommesser gemessenen Vorrichtung basierend auf der Änderungsanweisung zu ändern.

5. Informations-Verarbeitungsvorrichtung nach einem der Ansprüche 1 bis 4, wobei der Informationsprozessor anhand einer für die durch die ersten Strommesser gemessenen Vorrichtungen vordefinierten Abtastbedingung die Stromdaten der durch die ersten Strommesser gemessenen Vorrichtungen abtastet, und weiter Indizes, die aus den abgetasteten Stromdaten berechnet werden, als die Trainingsdaten verwendet.

6. Informations-Verarbeitungsvorrichtung nach Anspruch 5, wobei
   die Abtastbedingung Minimal- und Maximalwertebereiche der Stromdaten der Vorrichtungen einstellt.

7. Informations-Verarbeitungsvorrichtung nach Anspruch 5, wobei
   die Abtastbedingung eine Wahrscheinlichkeitsverteilung für die Stromdaten der Vorrichtungen zum Folgen einstellt.

8. Informations-Verarbeitungsvorrichtung nach Anspruch 6 oder 7, wobei
   die Abtastbedingung ein Verhältnis der Anzahl von Abtastungen von den Vorrichtungen entsprechend den ersten Strommessern einstellt.

9.  Informations-Verarbeitungsvorrichtung nach einem der Ansprüche 1 bis 8, wobei der Schätzprozessor für die Stromdaten der durch den zweiten Strommesser gemessenen Vorrichtung k-Punkte nächster Stromdaten aus den Stromdaten der durch die ersten Strommesser gemessenen Vorrichtungen in Bezug auf eine Distanz, basierend auf dem Index, spezifiziert,
    die spezifizierten k Punkte von Stromdaten pro der durch die ersten Strommesser gemessenen Vorrichtungen spezifiziert, um die Anzahl von Punkten von Stromdaten pro Vorrichtung zu ermitteln, und
    basierend auf der Anzahl von Punkten von Stromdaten pro Vorrichtung die Vielzahl von Kandidaten für einen Vorrichtungstyp der Vorrichtung, welche durch den zweiten Strommesser gemessen sind, und der Wahrscheinlichkeiten, mit welchen die Kandidaten mit dem zweiten Strommesser verbunden sind, abschätzt.

10. Informations-Verarbeitungsvorrichtung nach Ansprüchen 1 bis 8, wobei
    der Schätzprozessor einen Entscheidungsbaum zum Spezifizieren einer von Regionen erzeugt, die durch Werte eines Index, basierend auf den Trainingsdaten, getrennt sind,
    der Schätzprozessor eine Region des Index spezifiziert, der aus den durch den zweiten Strommesser gemessenen Vorrichtungsstromdaten berechnet wird, basierend auf dem Entscheidungsbaum,
    der Schätzprozessor die Anzahl von Indizes spezifiziert, die pro Vorrichtung aus den Stromdaten der durch die ersten Strommesser in der spezifizierten Region gemessenen Vorrichtungen berechnet sind, und
    der Schätzprozessor die Vielzahl von Kandidaten für einen Vorrichtungstyp der Vorrichtung abschätzt, welche durch einen zweiten Strommesser gemessen wird, und der Wahrscheinlichkeiten, mit welchen die Kandidaten mit dem zweiten Strommesser verbunden sind, basierend auf der Anzahl von Indizes, die pro Vorrichtung in der spezifizierten Region berechnet werden.

11. Informations-Verarbeitungsverfahren, umfassend:

    Einlesen (101) von Korrespondenzinformation, die Typen von Vorrichtungsvorrichtungen angeben, welche durch die ersten Strommesser einer Vielzahl von Strommessern gemessen werden, wobei die Vielzahl von Strommessern den Stromverbrauch von Vorrichtungen entsprechend der Vielzahl von Strommessern misst, um Stromdaten der Vielzahl von Vorrichtungen zu erfassen;
    Berechnen (101) eines Index aus den Stromdaten;
    Schätzen (107) einer Vielzahl von Kandidaten für einen Vorrichtungstyp der Vorrichtung, die durch einen zweiten Strommesser gemessen wird, und Wahrscheinlichkeiten, mit welchen die Kandidaten mit dem zweiten Strommesser verbunden sind, basierend auf einem aus Stromdaten der Vorrichtung, die durch den zweiten Strommesser gemessenen sind, berechneten Index, und Trainingsdaten, welche Indizes sind, die aus den Stromdaten der durch die ersten Strommesser gemessenen Vorrichtungen berechnet werden, wobei der zweite Strommesser in der Vielzahl von Strommessern enthalten ist und ein anderer ist als die ersten Strommesser; und
    Visualisieren (105) der Vielzahl von Kandidaten für den Vorrichtungstyp und der Wahrscheinlichkeiten, mit welchen die Kandidaten mit dem zweiten Strommesser verbunden sind.

**Revendications**

1.  Dispositif de traitement d'informations comprenant :

    un lecteur (101) configuré pour lire des informations de correspondance indiquant des types de dispositifs de dispositifs mesurés par des premiers compteurs d'énergie d'une pluralité de compteurs d'énergie, la pluralité de compteurs d'énergie mesurant la consommation d'énergie de dispositifs correspondant à la pluralité de compteurs d'énergie pour acquérir des données d'énergie de la pluralité de dispositifs ;
    un calculateur d'indice (101) configuré pour calculer un indice à partir des données d'énergie ;
    un processeur d'estimation (107) configuré pour estimer une pluralité de candidats pour un type de dispositif d'un dispositif mesuré par un deuxième compteur d'énergie et des probabilités auxquelles les candidats sont connectés au deuxième compteur d'énergie sur la base d'un indice calculé à partir de données d'énergie du dispositif mesuré par le deuxième compteur d'énergie et de données d'apprentissage qui sont des indices calculés à partir des données d'énergie des dispositifs mesurés par les premiers compteurs d'énergie, le deuxième compteur d'énergie étant inclus dans la pluralité de compteurs d'énergie et étant différent des premiers compteurs d'énergie ; et
    un visualisateur (105) configuré pour visualiser la pluralité de candidats pour le type de dispositif et les probabilités auxquelles les candidats sont connectés au deuxième compteur d'énergie.

2. Dispositif de traitement d'informations selon la revendication 1, comprenant en outre :
un acquéreur d'informations (106) configuré pour recevoir une instruction de réglage désignant le type de dispositif mesuré par le deuxième compteur d'énergie et régler le type de dispositif du dispositif mesuré par le deuxième compteur d'énergie dans les informations de correspondance sur la base de l'instruction de réglage.

3. Dispositif de traitement d'informations selon la revendication 2, dans lequel
le processeur d'estimation spécifie, à l'aide d'indices calculés à partir de données d'énergie du dispositif mesuré par certains des premiers compteurs d'énergie en tant que données d'apprentissage, un candidat pour le type de dispositif du dispositif mesuré par un troisième compteur d'énergie sur la base d'un indice calculé à partir de données d'énergie du dispositif mesuré par le troisième compteur d'énergie, le troisième compteur d'énergie étant sélectionné parmi des compteurs d'énergie restants des premiers compteurs d'énergie, et
le visualisateur visualise le type de dispositif du dispositif connecté au troisième compteur d'énergie spécifié par les informations de correspondance et le candidat du type de dispositif spécifié par le processeur d'estimation.

4. Dispositif de traitement d'informations selon la revendication 3, dans lequel
l'acquéreur d'informations reçoit une instruction de modification désignant le type de dispositif du dispositif mesuré par le troisième compteur d'énergie et met à jour les informations de correspondance afin de modifier le type de dispositif du dispositif mesuré par le troisième compteur d'énergie sur la base de l'instruction de modification.

5. Dispositif de traitement d'informations selon l'une quelconque des revendications 1 à 4, dans lequel
le processeur d'estimation échantillonne, en fonction d'une condition d'échantillonnage prédéfinie pour les dispositifs mesurés par les premiers compteurs d'énergie, les données d'énergie des dispositifs mesurés par les premiers compteurs d'énergie et utilise en outre des indices calculés à partir des données d'énergie échantillonnées en tant que données d'apprentissage.

6. Dispositif de traitement d'informations selon la revendication 5, dans lequel
la condition d'échantillonnage règle des plages de valeurs minimale et maximale des données d'énergie des dispositifs.

7. Dispositif de traitement d'informations selon la revendication 5, dans lequel
la condition d'échantillonnage règle une distribution de probabilité pour les données d'énergie des dispositifs à suivre.

8. Dispositif de traitement d'informations selon la revendication 6 ou 7, dans lequel
la condition d'échantillonnage règle un rapport du nombre d'échantillons parmi les dispositifs correspondant aux premiers compteurs d'énergie.

9. Dispositif de traitement d'informations selon l'une quelconque des revendications 1 à 8, dans lequel
le processeur d'estimation spécifie, pour les données d'énergie du dispositif mesuré par le deuxième compteur d'énergie, k points de données d'énergie les plus proches parmi les données d'énergie des dispositifs mesurés par les premiers compteurs d'énergie par rapport à une distance basée sur l'indice,
agrège les k points de données d'énergie spécifiés pour le dispositif mesurés par les premiers compteurs d'énergie pour obtenir le nombre de points de données d'énergie pour le dispositif, et
estime, sur la base du nombre de points de données d'énergie pour le dispositif, la pluralité de candidats pour un type de dispositif du dispositif mesuré par le deuxième compteur d'énergie et les probabilités auxquelles les candidats sont connectés au deuxième compteur d'énergie.

10. Dispositif de traitement d'informations selon les revendications 1 à 8, dans lequel
le processeur d'estimation génère un arbre de décision pour spécifier l'une parmi des régions séparées par des valeurs d'un indice basé sur les données d'apprentissage,
le processeur d'estimation spécifie une région de l'indice calculé à partir des données d'énergie du dispositif mesuré par le deuxième compteur d'énergie sur la base de l'arbre de décision,
le processeur d'estimation spécifie le nombre d'indices calculés pour le dispositif à partir des données d'énergie des dispositifs mesurés par les premiers compteurs d'énergie dans la région spécifiée, et
le processeur d'estimation estime la pluralité de candidats pour un type de dispositif du dispositif mesuré par un deuxième compteur d'énergie et les probabilités auxquelles les candidats sont connectés au deuxième compteur d'énergie, sur la base du nombre d'indices calculés pour le dispositif dans la région spécifiée.

**11.** Procédé de traitement d'informations comprenant :

la lecture en entrée (101) d'informations de correspondance indiquant des types de dispositif de dispositifs mesurés par des premiers compteurs d'énergie d'une pluralité de compteurs d'énergie, la pluralité de compteurs d'énergie mesurant la consommation d'énergie de dispositifs correspondant à la pluralité de compteurs d'énergie pour acquérir des données d'énergie de la pluralité de dispositifs ;

le calcul (101) d'un indice à partir des données d'énergie ;

l'estimation (107) d'une pluralité de candidats pour un type de dispositif du dispositif mesuré par un deuxième compteur d'énergie et des probabilités auxquelles les candidats sont connectés au deuxième compteur d'énergie sur la base d'un indice calculé à partir de données d'énergie du dispositif mesuré par le deuxième compteur d'énergie et de données d'apprentissage qui sont des indices calculés à partir des données d'énergie des dispositifs mesurés par les premiers compteurs d'énergie, le deuxième compteur d'énergie étant inclus dans la pluralité de compteurs d'énergie et étant différent des premiers compteurs d'énergie ; et

la visualisation (105) de la pluralité de candidats pour le type de dispositif et des probabilités auxquelles les candidats sont connectés au deuxième compteur d'énergie.

FIG. 1

EP 3 048 566 B1

FIG. 2

107 : ESTIMATION PROCESSOR

CORRESPONDENCE INFORMATION BETWEEN
POWER METER AND DEVICE

| POWER METER | DEVICE |
|---|---|
| 1 | IH COOKING HEATER |
| 2 | WASHER |
| 3 | ? |
| 4 | ? |
| ⋮ | ⋮ |

# FIG. 3

POWER OF METER 1

| TIME (MINUTES) | AVERAGE POWER (W) |
|---|---|
| 2013-01-01 11:30 | 500 |
| 2013-01-01 11:31 | 532 |
| 2013-01-01 11:32 | 561 |
| 2013-01-01 11:33 | 588 |
| ⋮ | ⋮ |

# FIG. 4

POWER AMOUNT DURING ON TIME

MAXIMUM VALUE

AVERAGE

POWER

TIME

AVERAGE AND STANDARD DEVIATION DURING ON TIME

FREQUENCY DISTRIBUTION

FREQUENCY

POWER

MEDIAN CALCULATED FROM FREQUENCY DISTRIBUTION OR PARAMETER OF PROBABILITY DISTRIBUTION APPROXIMATION TO FREQUENCY DISTRIBUTION

FIG. 5

EP 3 048 566 B1

DATA ASSOCIATED TO DEVICE

DISPLAY DEVICES OF k TRAINING
DATA POINTS AROUND ESTIMATION
TARGET DATA POINT AS CANDIDATES

k POINTS DETECTED

# FIG. 6

DISTRIBUTION OF DEVICE CANDIDATES WHEN k = 50

| DEVICE | THE NUMBER OF DATA POINTS | PERCENTAGE |
|--------|---------------------------|------------|
| TV     | 30                        | 0.60       |
| PC     | 15                        | 0.30       |
| AUDIO  | 5                         | 0.10       |

# FIG. 7

POWER METER 1: TV

POWER METER 2:
UNKNOWN!!

POWER METER 3: PC
⋮

POWER METER 2

CONNECTED DEVICE: UNKNOWN!!

■ DEVICE CANDIDATES

①TV        60%    □
②PC        30%    □
③AUDIO     10%    □
④OTHER            □

SET

# FIG. 8

FIG. 9

FIG. 10

```
                    ┌─────────────────────┐
                    │        START        │
                    └─────────────────────┘
                               │
                               ▼
   ┌──────────────────────────────────────────────────┐
   │        CONVERT POWER DATA INTO INDICES            │───S100
   └──────────────────────────────────────────────────┘
                               │
                               ▼
   ┌──────────────────────────────────────────────────┐
   │          DIVIDE INTO INDEX VALUE OF POWER DATA    │
   │          FROM ASSOCIATED POWER METER AND          │───S101
   │          INDEX VALUE OF POWER DATA FROM           │
   │          NON-ASSOCIATED POWER METER               │
   └──────────────────────────────────────────────────┘
                               │
                               ▼
   ┌──────────────────────────────────────────────────┐
   │    CALCULATE DEVICE CANDIDATE ESTIMATION MODEL    │
   │         FROM INDEX VALUE OF POWER DATA            │───S102
   │          FROM ASSOCIATED POWER METER             │
   └──────────────────────────────────────────────────┘
                               │
                               ▼
   ┌──────────────────────────────────────────────────┐
   │      INPUT INDEX VALUE OF POWER DATA FROM         │
   │        NON-ASSOCIATED POWER METER TO             │───S103
   │         DEVICE CANDIDATE ESTIMATOR               │
   └──────────────────────────────────────────────────┘
                               │
                               ▼
   ┌──────────────────────────────────────────────────┐
   │  ESTIMATE CANDIDATES FOR DEVICE (DEVICE TYPE)     │
   │ CONNECTED TO NON-ASSOCIATED POWER METER          │───S104
   │ BASED ON DEVICE CANDIDATE ESTIMATION MODEL       │
   └──────────────────────────────────────────────────┘
                               │
                               ▼
   ┌──────────────────────────────────────────────────┐
   │   DISPLAY DEVICE CANDIDATE ESTIMATION RESULTS     │───S105
   └──────────────────────────────────────────────────┘
                               │
                               ▼
   ┌──────────────────────────────────────────────────┐
   │  ACQUIRE DEVICE CORRESPONDENCE INFORMATION        │
   │    SET BY RESIDENT FOR DEVICE CANDIDATE          │───S106
   │ ESTIMATION RESULTS, AND REGIST INFORMATION       │
   │         IN POWER INFORMATION DB                  │
   └──────────────────────────────────────────────────┘
                               │
                               ▼
                    ┌─────────────────────┐
                    │         END         │
                    └─────────────────────┘
```

**FIG. 11**

EP 3 048 566 B1

```
                              ┌─────────────────┐
                              │   POWER DATA    │
                         100  │   COLLECTOR     │──────108          106
                              └─────────────────┘
                                      │                        ┌──────────────┐
  ┌───────────────┐                   │                        │    DEVICE    │
  │               │                   ▼                        │CORRESPONDENCE│
  │     POWER     │◄──────────────────────────────────────────│ INFORMATION  │
  │ INFORMATION DB│                                            │   ACQUIRER   │
  │               │                                            └──────────────┘
  └───────────────┘
       101  │          102                 103          110            109
            ▼
  ┌───────────────┐  ┌──────────────┐  ┌──────────────┐  ┌──────────────┐  ┌──────────┐
  │     INDEX     │  │     DATA     │  │DEVICE CANDIDATE│ │VIRTUAL POWER │  │  DEVICE  │
  │   CONVERTER   │─►│   DIVIDER    │─►│ESTIMATION MODEL│◄│DATA GENERATOR│◄─│REFERENCE │
  │               │  │              │  │  CALCULATOR    │ │              │  │    DB    │
  └───────────────┘  └──────────────┘  └──────────────┘  └──────────────┘  └──────────┘
                            │             104  │            105
                            │                  ▼
                            │          ┌──────────────┐  ┌──────────────┐
                            └─────────►│DEVICE CANDIDATE│─►│DEVICE CANDIDATE│
                                       │   ESTIMATOR  │  │  VISUALIZER  │
                                       └──────────────┘  └──────────────┘
```

# FIG. 12

107 : ESTIMATION PROCESSOR

TABLE OF DEVICE REFERENCE DB

| DEVICE | INDEX 1, MAXIMUM POWER (W) | | INDEX 2, *** | | DEVICE COMPONENT RATIO |
|---|---|---|---|---|---|
| | MINIMUM VALUE | MAXIMUM VALUE | MINIMUM VALUE | MAXIMUM VALUE | |
| WASHER | 300 | 1200 | ● ● ● | ● ● ● | 0.30 |
| TV | 50 | 130 | ● ● ● | ● ● ● | 0.15 |
| AUDIO | ● ● ● | ● ● ● | ● ● ● | ● ● ● | 0.05 |
| PC | ● ● ● | ● ● ● | ● ● ● | ● ● ● | 0.20 |
| ⋮ | ⋮ | ⋮ | ⋮ | ⋮ | ⋮ |

## FIG. 13

EP 3 048 566 B1

FIG.14A

FIG.14B

FIG.14C

FIG.14D

FIG.14E

FIG.14F

EP 3 048 566 B1

TABLE OF DEVICE REFERENCE DB

| DEVICE | NORMAL DISTRIBUTION 1 | | | | NORMAL DISTRIBUTION 2 | | | DEVICE COMPONENT RATIO |
| --- | --- | --- | --- | --- | --- | --- | --- | --- |
| | AVERAGE | VARIANCE-COVARIANCE MATRIX | SELECTION RATIO | AVERAGE | VARIANCE-COVARIANCE MATRIX | SELECTION RATIO | | |
| WASHER | (200, 100) | $\begin{pmatrix} 30 & 20 \\ 20 & 50 \end{pmatrix}$ | 0.6 | • • • | • • • | 0.4 | | 0.30 |
| TV | • • • | • • • | • • • | • • • | • • • | • • • | | 0.15 |
| AUDIO | • • • | • • • | • • • | • • • | • • • | • • • | | 0.05 |
| PC | • • • | • • • | • • • | • • • | • • • | • • • | | 0.20 |
| ⋮ | ⋮ | ⋮ | ⋮ | ⋮ | ⋮ | ⋮ | | ⋮ |

FIG. 15

EP 3 048 566 B1

FIG.16A

FIG.16B

FIG.16C

FIG.16D

FIG.16E

FIG.16F

INDEX 1

INDEX 2

MIXED NORMAL DISTRIBUTION

EP 3 048 566 B1

◯ POWER METER 1: TV

◯ POWER METER 2:
TV (CHANGED?)

◯ POWER METER 3: PC

⋮

◯ POWER METER 2

CONNECTED DEVICE: CHANGED?

■ DEVICE CANDIDATES

①AUDIO    70%   ☐
②TV       20%   ☐
①PC       10%   ☐

SET

# FIG. 17

FIG. 18